# EUROPÄISCHE PATENTSCHRIFT

(11) **EP 0 862 814 B1**
(45) Veröffentlichungstag und Bekanntmachung des Hinweises auf die Patenterteilung: **01.12.2004**
(21) Anmeldenummer: 97943732.4
(22) Anmeldetag: 03.09.1997
(51) Int. Cl.: H03J 1/00

(54) **VERFAHREN ZUR AUSWAHL EINER SENDEFREQUENZ**
METHOD OF SELECTING A TRANSMIT FREQUENCY
PROCEDE DE SELECTION D'UNE FREQUENCE EMETTRICE

(30) Priorität: 20.09.1996 DE 19638482
(43) Veröffentlichungstag der Anmeldung: 09.09.1998
(73) Patentinhaber: ROBERT BOSCH GMBH, 70442 Stuttgart (DE)
(72) Erfinder: HEGELER, Wilhelm, D-31134 Hildesheim (DE)
(86) Internationale Anmeldenummer: PCT/DE1997/001926
(87) Internationale Veröffentlichungsnummer: WO 1998/012811

(56) Entgegenhaltungen:
- EP-A- 0 502 500
- EP-A- 0 669 714
- PATENT ABSTRACTS OF JAPAN vol. 013, no. 323 (E-791), 21.Juli 1989 & JP 01 090609 A (CLARION CO LTD), 7.April 1989,

## Beschreibung

### Stand der Technik

Die Erfindung geht von einem Verfahren zur Auswahl einer zu einer an einem Rundfunkempfänger eingestellten Sendefrequenz alternativen Sendefrequenz nach der Gattung des Hauptanspruchs aus.

Aus den "Specifications of the Radio Data System RDS for VHF/FM Sound Broadcasting" der European Broadcasting Union vom März 1984 ist es bekannt, neben den Rundfunkprogrammen im Rahmen des Radio-Daten-Systems, kurz RDS, über die Rundfunksendefrequenzen Informationen in Form digitaler Signale zu übertragen. Teil dieser Informationen sind den Sendefrequenzen bzw. den über die Sendefrequenzen übertragenen Programmen zugeordnete Programmkennungen, darunter sogenannte Programmkettenkennungen (Program Identifier, kurz PI), die angeben, welches Programm über die jeweilige Sendefrequenz übertragen wird.

Des weiteren wird in der genannten Schrift ein Rundfunkempfänger vorgeschlagen, der bei schlechter werdendem Empfang eines über eine eingestellte Sendefrequenz übertragenen Programms automatisch auf eine alternative Sendefrequenz mit höherer Empfangsfeldstärke umschaltet, sofern der alternativen Sendefrequenz dieselbe Programmkettenkennung PI wie der ursprünglichen Sendefrequenz zugeordnet ist.

EP-A-0 502 500 offenbart ein bestimmtes Verfahren zur Verwaltung bzw. Prüfung von zu einer aktuell empfangenen Rundfunkfrequenz alternativen Rundfunkfrequenzen. Dort wird eine Alternativfrequenztabelle mit zu einer eingestellten Rundfunkfrequenz alternativen Rundfunkfrequenzen, das heißt solche Rundfunkfrequenzen, die mutmaßlich dasselbe Rundfunkprogramm wie die aktuelle Rundfunkfrequenz übertragen, angelegt. In dieser Alternativfrequenztabelle werden alle gespeicherten Rundfunkfrequenzen bewertet und aus der Bewertung eine Rangfolge der Rundfunkfrequenzen bestimmt. Diese Rangfolge ist Grundlage für eine Alternativfrequenzprüfung für den Fall, dass die Qualität der aktuell eingestellten Rundfunkfrequenz unter einen Schwellwert fällt. Dieser Schwellwert wird bei Einstellung der aktuellen Rundfunkfrequenz aus dem Mittelwert ihrer Empfangsfeldstärke abzüglich eines bestimmten Werts gebildet und entweder in Abhängigkeit der Zeit ab Einstellung der Rundfunkfrequenz oder in Abhängigkeit einer zurückgelegten Wegstrecke ab Einstellung der Rundfunkfrequenz kontinuierlich erhöht. Der Schwellwert ist also nicht konstant oder fest, sondern stetig steigend. Dies hat zwangsläufig zur Folge, dass nach ein bestimmten Zeit die mittlere gemessene Empfangsqualität der aktuell eingestellten Rundfunkfrequenz unter den Schwellwert abfällt. Dieses Unterschreiten des Schwellwerts wird als Auslöser zur Prüfung einer, hier der in der Tabelle als am besten zu empfangenden Altemativfrequenz gekennzeichneten Rundfunkfrequenz verwendet. Es wird also die gemäß Kennzeichnung am besten zu empfangende Rundfunkfrequenz aus der Altemativfrequenztabelle statt der aktuell empfangenen Rundfunkfrequenz eingestellt und deren Empfangsqualität geprüft. Ist diese höher als die der bisher eingestellten Rundfunkfrequenz, so wird diese soeben eingestellte Rundfunkfrequenz als nun aktuelle Rundfunkfrequenz beibehalten. Demzufolge wird der genannte Schwellwert aus der Empfangsqualität der nun neu eingestellten Rundfunkfrequenz ermittelt. Eine erneute Altemativfrequenzprüfung erfolgt also dann, wenn die Empfangsqualität der neu eingestellten Rundfunkfrequenz wieder unter den neu bestimmten Schwellwert fällt.

### Vorteile der Erfindung

Das erfindungsgemäße Verfahren mit den Merkmalen des Hauptanspruchs hat demgegenüber den Vorteil, daß die Anzahl der besonders zeitaufwendigen Vergleiche der Programmkennungen auf ein Minimum reduziert wird. Des weiteren ist es von Vorteil, daß durch Wiederholen der Vergleichsoperationen auf einfache Weise diejenige der verfügbaren Sendefrequenzen ermittelt wird, die bei korrekter Programmkennung die höchste Empfangsfeldstärke aufweist.

Durch Festlegen des Vergleichswertes zur Ermittlung einer besser zu empfangenden Frequenz auf den Wert der Empfangsfeldstärke zuzüglich einer Konstanten ist es möglich, die Vergleichsoperationen auf solche Sendefrequenzen zu beschränken, deren Empfangsfeldstärke um ein vorgegebenes Maß über der der zuvor empfangenen Frequenz liegt, wodurch die Anzahl der Vergleichsoperationen weiter beschränkt werden kann.

Durch Festlegen des Vergleichswertes zur Ermittlung einer besser zu empfangenden Frequenz auf den Wert der Empfangsfeldstärke abzüglich eines vorgegebenen Werts, können weitere Kriterien zur Beurteilung der Empfangsqualität einer Sendefrequenz herangezogen werden. Ein besonders vorteilhaft anzuwendendes Kriterium ist dabei die Störungsfreiheit einer Sendefrequenz.

Werden die zu vergleichenden potentiellen alternativen Frequenzen im Rahmen eines Sendersuchlaufs über das interessierende Frequenzband ermittelt, so ist es von Vorteil, den Sendersuchlauf bei der aktuell am Empfänger eingestellten Frequenz zu starten und vor deren Wiedererreichen zu stoppen, da auf diese Weise ausgeschlossen wird, daß die ursprünglich eingestellte Frequenz nach Ermittlung einer Alternativen wieder als bessere Alternative beurteilt wird.

### Zeichnungen

Ausführungsbeispiele der Erfindung sind in den Zeichnungen dargestellt und werden in der nachfolgenden Beschreibung näher erläutert.
Es zeigen:
Figur 1 ein Blockschaltbild des erfindungswesentlichen Teils eines Rundfunkempfängers zur Durchführung des erfindungsgemäßen Verfahrens und
Figur 2 einen Ablaufplan eines bevorzugten Ausführungsbeispiels des erfindungsgemäßen Verfahrens.

### Beschreibung eines Ausführungsbeispiels

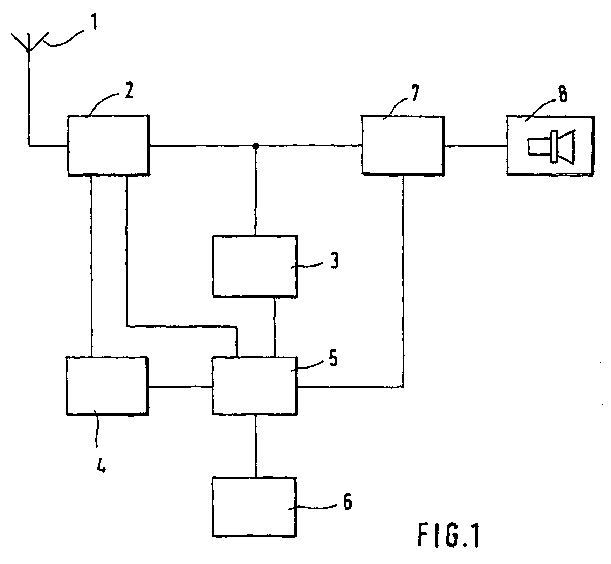

In Figur 1 ist der erfindungswesentliche Teil eines Rundfunkempfängers zur Durchführung des erfindungsgemäßen Verfahrens dargestellt.

Einem Empfangsteil 2, das über die zum Empfang und zur Demodulation eines trägerfrequenten Eingangssignals erforderlichen Mittel verfügt, ist ein Eingangssignal über eine Antenne 1 zugeführt. Ein erster Ausgang des Empfangsteils 2, an dem das aus dem Empfangssignal gewonnene Stereo-Multiplexsignal mit dem überlagerten, den 57 kHz-Hilfsträger des Stereo-Multiplexsignals modulierenden Radio-Daten-Signal ansteht, ist einer ersten Auswerteeinheit 3 zur Dekodierung des Radio-Daten-Signals zugeführt. Ein zweiter Ausgang des Empfangsteils 2 ist mit einer zweiten Auswerteeinheit 4 zur Bestimmung der Empfangsfeldstärke FS und des Störgrads der empfangenen Sendefrequenz verbunden.

Die Ausgangssignale der ersten und der zweiten Auswerteeinheit 3 und 4 sind einer Steuereinheit 5 zugeführt, die mit einem Speicher 6 zum Ablegen einer alternativen Sendefrequenz und über eine Steuerleitung mit dem Empfangsteil 2 in Verbindung steht.

Das am ersten Ausgang des Empfangsteils 2 anstehende Stereo-Multiplexsignal ist über eine von der Steuereinheit 5 angesteuerte Unterbrechungseinheit 7 einer Wiedergabeeinheit 8 zugeführt, die über die zur Wiedergabe der im Stereo-Multiplexsignal enthaltenen Audiosignale erforderlichen Mittel, also beispielsweise einen Stereo-Decoder, Verstärker und Lautsprecher, verfügt. Die Unterbrechungseinheit 7 dient dabei der Unterbrechung der Wiedergabe eines von der Empfangseinheit 2 abgegebenen Signals für die Dauer einer Alternativfrequenzprüfung. Im einfachsten Fall ist die Unterbrechungseinheit 7 als durch die Steuereinheit 5 ansteuerbarer Schalter ausgeführt. Alternativ kann die Unterbrechungseinheit 7 aber auch derart ausgebildet sein, daß während der Dauer einer Alternativfrequenzprüfung das von der Empfangseinheit 2 abgegebene Signal unterbrochen, und in die Signallücke ein der Unterbrechung unmittelbar vorausgehender zwischengespeicherter Signalabschnitt eingesetzt und über die Ausgabeeinheit 8 wiedergegeben wird. Eine solche Unterbrechungseinheit 7 ist beispielsweise in der DE-A-4 103 061 beschrieben.

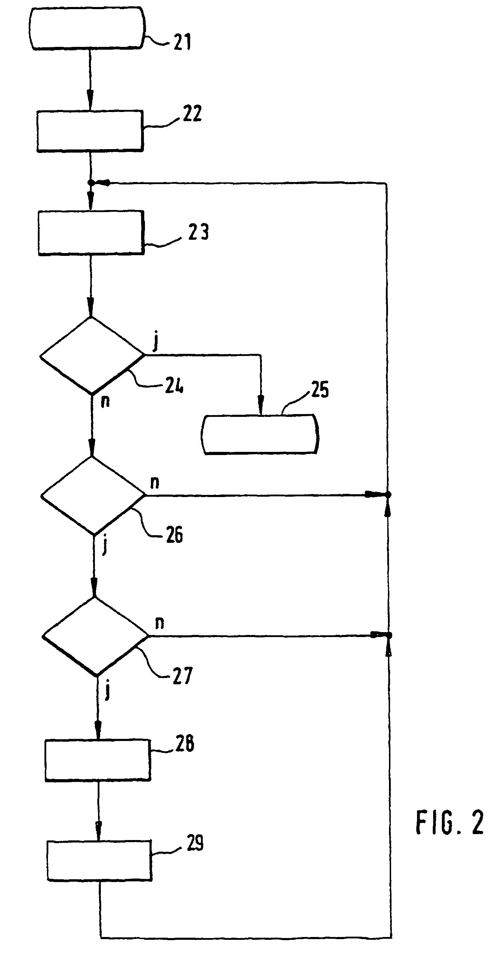

Das erfindungsgemäße Verfahren, dessen Ablauf im folgenden anhand des in Figur 2 dargestellten Ablaufdiagramms erläutert wird, ist in Form von Steuersoftware in der Steuereinheit 5 eines Rundfunkempfängers implementiert.

In der Steuereinheit 5 wird permanent die Empfangswürdigkeit der aktuell am Empfangsteil 2 eingestellten Sendefrequenz f₁ beurteilt. Diese Beurteilung erfolgt im einfachsten Fall durch Vergleich der Empfangsfeldstärke der Sendefrequenz f₁ mit einer Minimalfeldstärke MFS, wobei bei Unterschreiten der Minimalfeldstärke MFS die Suche nach einer alternativen, besser zu empfangenden Sendefrequenz f₂, ausgelöst wird (Programmschritt 21).

Daraufhin wird eine Vergleichsfeldstärke VFS aus der Empfangsfeldstärke FS der am Empfangsteil 2 eingestellten Sendefrequenz f₁ abgeleitet (22), im einfachsten Fall der Empfangsfeldstärke FS der Sendefrequenz f₁ gleichgesetzt und eine neue Sendefrequenz f₂ am Empfangssteil 2 eingestellt (23). Da diese neue Sendefrequenz f₂ nicht notwendig das gleiche Programm überträgt, wie die ursprüngliche Sendefrequenz f₁ und ein möglicher Programmwechsel nicht hörbar werden soll, wird die Wiedergabe des Audiosignals mittels der Unterbrechungseinheit 7 auf ein Signal der Steuereinheit 5 hin unterbrochen.

Im Programmschritt 24 wird eine Abbruchbedingung überprüft, die später im Zusammenhang mit Weiterbildungen des erfindungsgemäßen Verfahrens beschrieben wird und bei deren Erfüllung das Programm bei 25 beendet wird. Ist die Abbruchbedingung nicht erfüllt, so wird bei 26 geprüft, ob die Empfangsfeldstärke FS der neuen Frequenz f₂ größer als die Vergleichsfeldstärke VFS ist. Ist dies nicht der Fall, so kehrt das Programm zum Punkt 23 zurück, d.h. es wird eine weitere neue Frequenz f₂ am Empfangsteil 2 eingestellt.

Bei Überschreiten der Vergleichsfeldstärke VFS durch die Empfangsfeldstärke FS der neuen Frequenz f₂ wird bei 27 geprüft, ob die Programmkennung der neuen Sendefrequenz f₂ mit der der ursprünglichen Sendefrequenz f₁ übereinstimmt. Im negativen Fall wird bei 23 am Empfangsteil 2 eine weitere neue Frequenz f₂ eingestellt und die Vergleichsoperationen mit der weiteren neuen Sendefrequenz f₂ fortgesetzt.

Wird hingegen bei 27 eine Übereinstimmung der Programmkennungen festgestellt, so wird, da eine alternative Frequenz mit gleicher Programmkennung und besserer Empfangsqualität gefunden ist, bei 28 die neue Frequenz f₂ im Speicher 6 abgelegt, bzw. eine dort bereits abgelegte Sendefrequenz durch die neue Sendefrequenz f₂ überschrieben. Wird das Verfahren an dieser Stelle beendet, so steht im Speicher 6 eine alternative Sendefrequenz f₂, die bei gleicher Programmkennung über eine höhere Empfangsfeldstärke FS als die ursprüngliche Sendefrequenz f₁ verfügt. Nach Einstellen der im Speicher 6 abgelegten neuen Sendefrequenz f₂ am Empfangsteil 2 des Rundfunkempfängers, wird die Unterbrechung der Signalwiedergabe durch die Steuereinheit 5 aufgehoben und das empfangene Signal wiedergegeben.

Beim vorliegenden Ausführungsbeispiel ist es jedoch vorgesehen, daß die Vergleichsoperationen mit allen verfügbaren Sendefrequenzen durchgeführt werden. Dazu wird beim Programmschritt 29 die Vergleichsfeldstärke VFS aus der Empfangsfeldstärke FS der neuen Sendefrequenz f₂ neu abgeleitet, also im einfachsten Fall der Empfangsfeldstärke FS gleichgesetzt, woraufhin der Programmablauf beim Punkt 23 mit dem Einstellen einer weiteren neuen Sendefrequenz f₂ am Empfangsteil 2 fortgesetzt wird. Sind alle verfügbaren Sendefrequenzen überprüft, was dem Erfüllen der Abbruchbedingung 24 gleichkommt, so wird der Programmablauf bei 2S beendet.

Nach Beendigung des Verfahrens wird die im Speicher 6 abgelegte alternative Sendefrequenz am Empfangsteil 2 des Rundfunkempfängers eingestellt und die Unterbrechung der Wiedergabe des empfangenen Audiosignals aufgehoben. Am Empfangsteil ist nun diejenige Sendefrequenz aus der Gesamtmenge der verfügbaren Sendefrequenzen eingestellt, die bei mit der Programmkennung der ursprünglichen sendefrequenz f₁ übereinstimmenden Programmkennung über die höchste Empfangsqualität, im vorliegenden Fall über die höchste Empfangsfeldstärke, verfügt.

Vor der Rückkehr des Ablaufs zum Schritt 23, d. h. vor der Einstellung einer neuen Frequenz f₂ am Empfangsteil 2 kann es vorgesehen sein, kurzzeitig (z. B. für ca. 1 Sekunde) das Programm der ursprünglichen Sendefrequenz f₁ wiederzugeben. Dem liegt die Überlegung zugrunde, daß eine einzelne Programmunterbrechung, z. B. infolge einer Feldstärkeprüfung (ca. 8 ms), sich weniger stark bemerkbar macht als eine andauernde Programmunterbrechung durch mehrere unmittelbar aufeinanderfolgende Prüfungen.

Beim vorliegenden Ausführungsbeispiel ist es vorgesehen, daß die neuen Frequenzen f₂, die im Zuge des erfindungsgemäßen Verfahrens am Empfangsteil 2 eingestellt werden, aus einem Frequenzspeicher ausgelesen werden, in dem die am Empfängerstandort empfangbaren Sendefrequenzen abgelegt sind. In diesem Fall wird im Programmschritt 24 geprüft, ob bereits alle im Frequenzspeicher enthaltenen Sendefrequenzen überprüft worden sind. Ist dies der Fall, bricht das Verfahren ab.

Die Menge der verfügbaren neuen Frequenzen kann auch auf Teilmengen der im Speicher abgelegten Frequenzen beschränkt sein, so ist zum Beispiel eine Beschränkung der Vergleichsoperationen auf solche Sendefrequenzen möglich, die zuletzt als beste Alternative am Empfangsteil eingestellt waren, möglich.

Bei einer Weiterbildung des erfindungsgemäßen Verfahrens werden die neuen Frequenzen f₂ im Zuge eines Sendersuchlaufs über das durch die Sendefrequenzen belegte Frequenzband bestimmt. Dabei kann es vorgesehen sein, den Suchlauf am Beginn des Frequenzbandes zu starten und das Erreichen des Endes des Frequenzbandes als Abbruchbedingung zu definieren. Bei der vorliegenden Weiterbildung wird jedoch der Sendersuchlauf bei der aktuell eingestellten Sendefrequenz f₁ gestartet und bei Wiedererreichen der ursprünglichen Sendefrequenz f₁ abgebrochen.

Bei den zu überprüfenden Programmkennungen handelt es sich im vorliegenden Fall um die mittels des Radio-Daten-Systems über die jeweilige Sendefrequenz übertragenen Programmkettenkennungen (PI), so daß nur solche Sendefrequenzen als alternative Sendefrequenzen ausgewählt werden, über die das gleiche Rundfunkprogramm wie über die ursprüngliche Sendefrequenz f₁ übertragen wird.

Es ist jedoch beispielsweise auch möglich, die der jeweiligen Sendefrequenz zugeordnete Programmartkennung (PTY) des Radio-Daten-Systems, die anzeigt, welche Art von Programm (z.B. Nachrichten, Magazine, klassische Musik, Popmusik usw.) über die jeweilige Sendefrequenz übertragen wird, als Vergleichskriterium zu verwenden. Damit werden nur solche Sendefrequenzen als alternative Frequenzen ausgewählt, über die eine mit der über die ursprüngliche Sendefrequenz f₁ ausgestrahlten Programmart übereinstimmende Programmart ausgestrahlt werden.

Bei einer Weiterbildung des Verfahrens ist es vorgesehen, die Vergleichsfeldstärke VFS nicht nur der Empfangsfeldstärke FS einer zuvor empfangenen bzw. am Empfangsteil eingestellten Sendefrequenz gleichzusetzen, sondern um eine Konstante ε, zum Beispiel in der Höhe weniger Prozent der Empfangsfeldstärke FS, zu erhöhen. Auf diese Weise werden nur die Programmkennungen solcher Frequenzen f₂ überprüft, deren Empfangsfeldstärke um ein vorgegebenes Maß höher als die der zuletzt empfangenen Sendefrequenz liegt, so daß nur wirklich besser zu empfangende Sendefrequenzen als alternative Frequenzen ausgewählt werden.

Bei einer Weiterbildung des erfindungsgemäßen Verfahrens ist es vorgesehen, neben der Empfangsfeldstärke FS einer Sendefrequenz auch die Störungsfreiheit als Kriterium für die Empfangswürdigkeit der Sendefrequenz heranzuziehen. Dazu wird die Vergleichsfeldstärke VFS nicht der Empfangsfeldstärke der jeweiligen Sendefrequenz f₁, f₂ gleichgesetzt, sondern von diesem Wert ein Störungen im Empfangssignal repräsentierender vorgegebener Wert Δ subtrahiert. Auf diese Weise können auch solche Sendefrequenzen f₂ als alternative Sendefrequenzen ausgewählt werden, deren Empfangsfeldstärke FS kleiner als die der ursprünglichen Sendefrequenz f₁ ist, die aber möglicherweise geringere Störungen aufweisen.

Des weiteren kann es vorgesehen sein, den vorgegebenen Wert Δ aus einem Störungen im Empfangssignal anzeigenden Signal abzuleiten. Die Ableitung eines solchen Störungen anzeigenden Signals ist beispielsweise in der EP 94 911 060.5 der Anmelderin beschrieben, wobei die Störungen durch Hochpaßfilterung aus dem digitalen Stereo-Multiplexsignal isoliert und daraus durch Abtastratenreduzierung ein Störungen anzeigendes Signal gewonnen wird. Mit einem aus einem Störungen anzeigenden Signal abgeleiteten vorgegebenen Wert Δ werden mögliche Störungen nicht nur pauschal, sondern deren tatsächlicher Umfang in die Qualitätsbewertung einer Sendefrequenz einbezogen.

## Patentansprüche

1. Verfahren zur Auswahl einer zu einer an einem Rundfunkempfänger, insbesondere einem Autoradio, eingestellten Sendefrequenz alternativen Sendefrequenz,
wobei den Sendefrequenzen Programmkennungen zugeordnet sind, die neben den Programmen über die Sendefrequenzen übertragen werden,
wobei
- ein fester Vergleichswert (VFS) aus dem Wert (FS) der Empfangsfeldstärke der am Empfänger eingestellten Sendefrequenz (f1) abgeleitet wird,
- eine neue Frequenz (f2) am Empfangsteil des Rundfunkempfängers eingestellt, die Empfangsfeldstärke (FS) der neuen Frequenz bestimmt und mit dem Vergleichswert (VFS) verglichen wird,
- wobei bei Überschreiten des Vergleichswertes (VFS) durch die Empfangsfeldstärke (FS) der neuen Frequenz (f2) die der neuen Frequenz (f2) zugeordnete Programmkennung mit der der aktuellen Frequenz (f1) zugeordneten Programmkennung verglichen wird und nur bei Übereinstimmung der Programmkennungen der Inhalt eines Speichers durch die neue Frequenz (f2) überschrieben wird und der Vergleichswert (VFS) aus dem Wert der Empfangsfeldstärke (FS) der neuen Frequenz (f2) abgeleitet wird,
- wobei weitere Vergleichsoperationen mit weiteren verfügbaren Sendefrequenzen durchgeführt werden und der Vergleichswert (VFS) für die nachfolgenden Vergleichsoperationen jeweils aus dem Wert der Empfangsfeldstärke (FS) der jeweils neuen Frequenz (f2) abgeleitet wird.

2. Verfahren nach Anspruch 1,
**dadurch gekennzeichnet,**
**daß** die Vergleichsoperationen mit allen verfügbaren Sendefrequenzen durchgeführt werden.

3. Verfahren nach Anspruch 1 oder 2,
**dadurch gekennzeichnet,**
**daß** der Vergleichswert (VFS) dem Wert der Empfangsfeldstärke (FS) gleichgesetzt wird.

4. Verfahren nach einem der Ansprüche 1 bis 3,
**dadurch gekennzeichnet,**
**daß** der Vergleichswert (VFS) dem Wert der Empfangsfeldstärke (FS) zuzüglich einer Konstanten (ε) gleichgesetzt wird.

5. Verfahren nach Anspruch 1 oder 2,
**dadurch gekennzeichnet,**
**daß** der Vergleichswert (VFS) dem Wert (FS) der Empfangsfeldstärke FS abzüglich eines vorgegebenen Wertes (Δ) gleichgesetzt wird.

6. Verfahren nach Anspruch 5,
**dadurch gekennzeichnet,**
**daß** der vorgegebene Wert (Δ) aus einem Störungen der Empfangsfrequenz anzeigenden Signal abgeleitet wird.

7. Verfahren nach einem der Ansprüche 1 bis 6,
**dadurch gekennzeichnet,**
**daß** die neuen Frequenzen (f2) aus einem Frequenzspeicher eines Rundfunkempfängers ausgelesen werden,
und **daß** das Verfahren abgebrochen wird, wenn alle im Speicher verfügbaren Frequenzen überprüft worden sind.

8. Verfahren nach einem der Ansprüche 1 bis 6,
**dadurch gekennzeichnet,**
**daß** die neuen Frequenzen (f2) mittels eines Sendersuchlaufs aus dem durch die Sendefrequenzen belegten Frequenzband bestimmt werden.

9. Verfahren nach Anspruch 8,
**dadurch gekennzeichnet,**
**daß** der Sendersuchlauf bei der aktuell am Empfänger eingestellten Frequenz (f1) beginnt und nach Durchlaufen des durch die Sendefrequenzen belegten Frequenzbandes vor Wiedererreichen der aktuellen Frequenz (f1) abbricht.

## Claims

1. Method for selecting an alternative transmission frequency to a transmission frequency which is set on a broadcast radio receiver, particularly a car radio, the transmission frequencies having associated programme identifiers which are transmitted in addition to the programmes using the transmission frequencies,
where
- a fixed comparison value (VFS) is derived from the value (FS) of the reception field strength for the transmission frequency (f1) which is set on the receiver,
- a new frequency (f2) is set on the reception part of the broadcast radio receiver, and the reception field strength (FS) for the new frequency is determined and is compared with the comparison value (VFS),
- where, if the reception field strength (FS) for the new frequency (f2) exceeds the comparison value (VFS), the programme identifier associated with the new frequency (f2) is compared with the programme identifier associated with the current frequency (f1), and only if the programme identifiers match is the content of a memory overwritten by the new frequency (f2) and is the comparison value (VFS) derived from the value of the reception field strength (FS) for the new frequency (f2),
- where further comparison operations are performed with further available transmission frequencies, and the comparison value (VFS) for the subsequent comparison operations is respectively derived from the value of the reception field strength (FS) for the respective new frequency (f2).

2. Method according to Claim 1,
**characterized**
**in that** the comparison operations are performed with all available transmission frequencies.

3. Method according to Claim 1 or 2,
**characterized**
**in that** the comparison value (VFS) is equated to the value of the reception field strength (FS).

4. Method according to one of Claims 1 to 3,
**characterized**
**in that** the comparison value (VFS) is equated to the value of the reception field strength (FS) plus a constant (ε).

5. Method according to Claim 1 or 2,
**characterized**
**in that** the comparison value (VFS) is equated to the value (FS) of the reception field strength FS minus a prescribed value (Δ).

6. Method according to Claim 5,
**characterized**
**in that** the prescribed value (Δ) is derived from a signal indicating interference at the reception frequency.

7. Method according to one of Claims 1 to 6,
**characterized**
**in that** the new frequencies (f2) are read from a frequency memory in a broadcast radio receiver,
and **in that** the method is aborted when all of the frequencies available in the memory have been checked.

8. Method according to one of Claims 1 to 6,
**characterized**
**in that** the new frequencies (f2) are determined by means of a station search from the frequency band occupied by the transmission frequencies.

9. Method according to Claim 8,
**characterized**
**in that** the station search starts at the frequency (f1) which is currently set on the receiver and aborts after having swept the frequency band occupied by the transmission frequencies before the current frequency (f1) is reached again.

## Revendications

1. Procédé de sélection d'une fréquence émettrice alternative par rapport à une fréquence émettrice réglée sur un récepteur radio, notamment un autoradio, avec des codes de programme associés aux fréquences émettrices qui sont transmis parallèlement aux programmes par les fréquences émettrices,
selon lequel
- une valeur de comparaison (VFS) fixe est déduite de la valeur (FS) de l'intensité de champ de réception de la fréquence émettrice (f1) réglée sur le récepteur,
- une nouvelle fréquence (f2) est réglée sur la partie de réception du récepteur radio, l'intensité de champ de réception (FS) de la nouvelle fréquence étant déterminée et comparée avec la valeur de comparaison (VFS),
- lors d'un dépassement de la valeur de comparaison (VFS) par l'intensité de champ de réception (FS) de la nouvelle fréquence (f2) le code de programme associé à la nouvelle fréquence (f2) et comparé avec le code de programme associé à la fréquence actuelle (f1), et le contenu d'une mémoire n'est remplacé par la nouvelle fréquence (f2) qu'en cas de concordance des codes de programme, la valeur de comparaison (VFS) étant déduite de la valeur de l'intensité de champ de réception (FS) de la nouvelle fréquence (f2), et
- d'autres opérations de comparaison sont effectuées avec d'autres fréquences émettrices disponibles, la valeur de comparaison (VFS) pour les opérations de comparaison suivantes étant chaque fois déduite de la valeur de l'intensité de champ de réception (FS) de la nouvelle fréquence (f2) respective.

2. Procédé selon la revendication 1,
**caractérisé en ce que**
les opérations de comparaison sont effectuées avec toutes les fréquences émettrices disponibles.

3. Procédé selon la revendication 1 ou 2,
**caractérisé en ce que**
la valeur de comparaison (VFS) est assimilée à la valeur de l'intensité de champ de réception (FS).

4. Procédé selon l'une quelconque des revendications 1 à 3,
**caractérisé en ce que**
la valeur de comparaison (VFS) est assimilée à la valeur de l'intensité de champ de réception (FS) plus une constante (ε).

5. Procédé selon la revendication 1 ou 2,
**caractérisé en ce que**
la valeur de comparaison (VFS) est assimilée à la valeur de l'intensité de champ de réception (FS) moins une valeur prédéterminée (Δ).

6. Procédé selon la revendication 5,
**caractérisé en ce que**
la valeur prédéterminée (Δ) est déduite d'un signal indiquant des perturbations de la fréquence émettrice.

7. Procédé selon l'une quelconque des revendications 1 à 6,
**caractérisé en ce que**
les nouvelles fréquences (f2) sont lues dans une mémoire de fréquences d'un récepteur radio, et le procédé est interrompu lorsque toutes les fréquences disponibles dans la mémoire ont été vérifiées.

8. Procédé selon l'une quelconque des revendications 1 à 6,
**caractérisé en ce que**
les nouvelles fréquences (f2) sont déterminées au moyen d'une détection d'émetteur à partir de la bande de fréquences occupée par les fréquences émettrices.

9. Procédé selon la revendication 8,
**caractérisé en ce que**
la détection d'émetteur commence à la fréquence (f1) actuellement réglée sur le récepteur et se termine après le passage de la bande de fréquences occupée par les fréquences émettrices avant d'arriver à nouveau à la fréquence actuelle (fl).
